Europäisches Patentamt

European Patent Office

Office européen des brevets

(19)

(11) Numéro de publication: **0 133 388**
**A1**

(12) # DEMANDE DE BREVET EUROPEEN

(21) Numéro de dépôt: **84401340.9**

(51) Int. Cl.⁴: **H 03 L 1/02**

(22) Date de dépôt: **26.06.84**

(30) Priorité: **06.07.83 FR 8311257**

(43) Date de publication de la demande: **20.02.85
Bulletin 85/8**

(84) Etats contractants désignés: **CH DE GB LI**

(71) Demandeur: **THOMSON-CSF, 173, Boulevard
Haussmann, F-75379 Paris Cedex 08 (FR)**
Demandeur: **COMPAGNIE D'ELECTRONIQUE ET DE
PIEZO-ELECTRICITE - C.E.P.E., 44, rue de la Glacière,
F-95100 Argenteuil (FR)**

(72) Inventeur: **Swaenepoel, Joseph, THOMSON-CSF
SCPI 173, bld Haussmann, F-75379 Paris Cedex 08 (FR)**
Inventeur: **Thivet, Marc, THOMSON-CSF SCPI 173, bld
Haussmann, F-75379 Paris Cedex 08 (FR)**
Inventeur: **Marotel, Gérard, THOMSON-CSF
SCPI 173, bld Haussmann, F-75379 Paris Cedex 08 (FR)**

(74) Mandataire: **Courtellemont, Alain, THOMSON-CSF
SCPI 173, Bld Haussmann, F-75379 Paris Cedex 08 (FR)**

(54) **Générateur de fréquence compensé en température.**

(57) Générateur de fréquence, du type à oscillateur pilote à résonateur piézo-électrique, compensé en température.

La compensation est realisée à partir d'un oscillateur à résonateur piézo-électrique (2) utilisé comme capteur thermique; le choix de l'oscillateur capteur doit se porter sur un oscillateur dont la dérive en température est monotone et très supérieure à celle de l'oscillateur pilote dans la bande des températures de fonctionnement.

Le générateur comporte un fréquencemètre (4) pour mesurer la fréquence de l'oscillateur capteur et une mémoire (6) dont la sortie de commander les moyens de réglage (7, 8) de l'oscillateur pilote (1) en fonction du résultat de mesure.

Application aux cas où une grande stabilité, en fonction de la température, est nécessaire.

EP 0 133 388 A1

0133388

1

# Générateur de fréquence compensé en température

La présente invention concerne un générateur de fréquence compensé en température, comprenant un oscillateur pilote à résonateur piézo-électrique pour fournir un signal de sortie à fréquence stable, des moyens de mesure pour fournir un signal de mesure fonction de la température de l'oscillateur pilote, des moyens de réglage de la fréquence de l'oscillateur pilote et un circuit de commande pour commander les moyens de réglage en fonction du signal de mesure.

Il est connu de réaliser de tels générateurs en utilisant comme moyens de mesure un circuit dont le capteur thermique est formé par un oscillateur commandé, en fonction de la température, par une thermistance ; le résultat de la mesure est utilisé, grâce à une mémoire programmée suivie d'un convertisseur numérique-analogique, pour compenser la dérive en température de l'oscillateur pilote.

Cette solution connue présente des inconvénients. En particulier le capteur thermique n'est pas stable dans le temps et a des caractéristiques qui varient d'un échantillon à l'autre. Et il est à noter que l'emploi de convertisseurs numériques-analogiques ne permet pas la réalisation complète en circuits intégrés ; toutefois si la réalisation en circuits intégrés et la faible consommation d'énergie qui en découle ne sont pas recherchées, le générateur de référence selon l'invention peut comporter un convertisseur numérique-analogique.

La présente invention a pour but d'éviter ou pour le moins de réduire tout ou partie de ces inconvénients.

Ceci est principalement obtenu par une mesure de température à partir d'un capteur constitué par un oscillateur à résonateur piézo-électrique convenablement choisi.

Selon l'invention, un générateur de fréquence compensé en température, comprenant un oscillateur pilote à résonateur piézo-électrique pour fournir un signal de sortie à fréquence stable, des moyens de mesure pour effectuer une mesure de la température de l'oscillateur pilote, des moyens de réglage reliés à une entrée de commande de la fréquence de l'oscillateur pilote et un circuit de commande, couplé aux moyens de mesure et comportant un mémoire, pour commander les moyens de réglage en fonction du résultat de la mesure, les moyens de mesure comportant un oscillateur utilisé comme oscillateur capteur et un fréquencemètre ayant une entrée de mesure couplée à la sortie de l'oscillateur capteur, est caractérisé en ce que l'oscillateur capteur est un oscillateur à résonateur piézo-électrique dont la dérive en température est monotone et très supérieure (au moins de l'ordre de 20 fois) à celle de l'oscillateur pilote dans la bande des températures de fonctionnement de l'oscillateur pilote.

L'invention sera mieux comprise et d'autres caractéristiques apparaîtront à l'aide de la description ci-après et des figures s'y rapportant qui représentent :

- la figure 1, un générateur de fréquence selon l'invention,

- la figure 2, deux courbes relatives à des circuits de la figure 1, dessinées avec des échelles différentes en ordonnée,

- la figure 3, une vue plus détaillée d'un élément de la figure 1,

- la figure 4, un schéma partiel d'un autre générateur de fréquence selon l'invention.

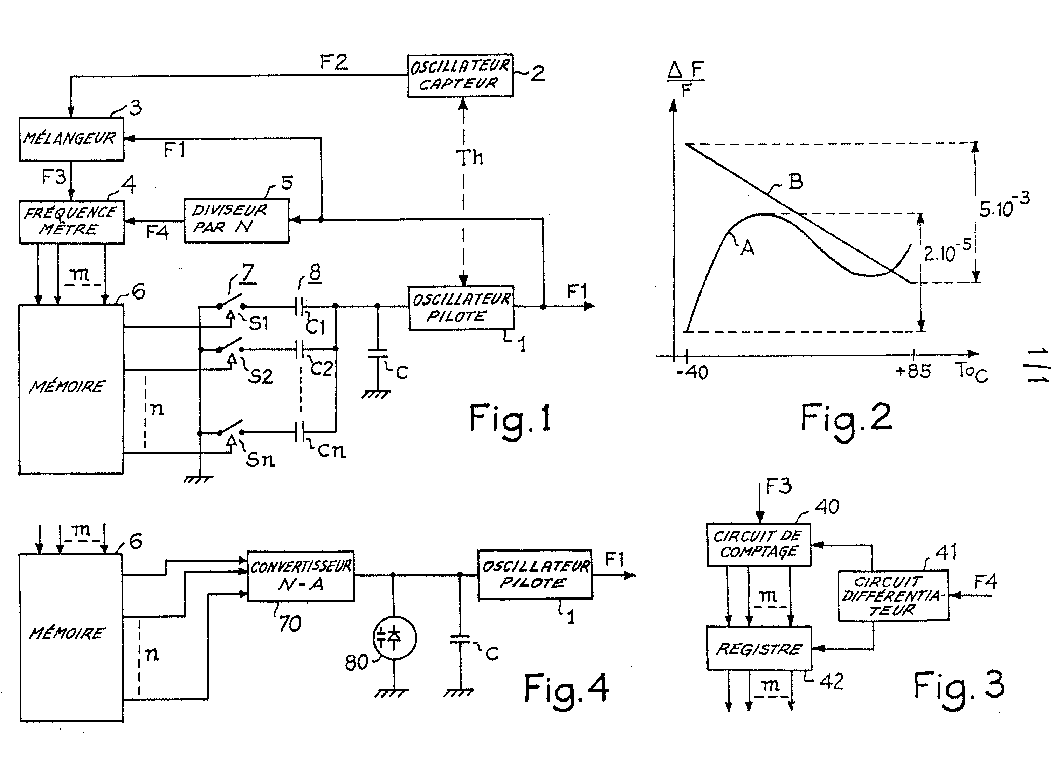

Sur les figures 1 et 4 les éléments correspondants portent les mêmes repères.

La figure 1 montre un générateur de fréquence dans une réalisation selon l'invention. Ce générateur comporte un oscillateur pilote à résonateur piézo-électrique, 1, de bonne stabilité en fréquence puisque seul, sans le montage de compensation de température qui l'entoure et qui va être décrit ci-après, il présente une dérive de $\pm 2.10^{-5}$ de $-40$ à $+85°C$ (voir figure 2, courbe A) ; il s'agit d'un oscillateur pilote formé d'un circuit oscillateur INTERSIL 7038 associé à un quartz, de coupe AT, pour donner une fréquence F1 de 5 MHz.

Pour stabiliser en température la fréquence de sortie, F1, de l'oscillateur pilote de la figure 1 il est prévu un capteur thermique constitué par un oscillateur à résonateur piézo-électrique, 2, dont le résonateur piézo-électrique est fortement connecté thermiquement (liaison Th) au résonateur piézo-électrique de l'oscillateur pilote ; dans l'exemple décrit les boîtiers des deux résonateurs piézo-électriques étaient accolés. L'oscillateur capteur 2 n'est pas compensé en température et est choisi intentionnellement de façon à présenter une dérive en température très supérieure à celle de l'oscillateur pilote : dérive de $\pm 4.10^{-5}$ par degré Celsius, soit $\pm 5.10^{-3}$ de $- 40$ à $+ 85°C$, ce qui représente une dérive 250 fois plus grande que celle de l'oscillateur pilote. D'une façon générale il faut, comme cela ressortira de la suite de la description, que dans la bande des températures de fonctionnement, la dérive de l'oscillateur pilote non compensé en température soit négligeable devant celle de l'oscillateur capteur ; il y a intérêt à prendre un rapport d'au moins 100 entre les dérives de l'oscillateur capteur et de l'oscillateur pilote mais un rapport de 20 pourrait, par exemple, encore convenir même s'il conduisait à de moins bons résultats.

Comme le montre la figure 2 la loi de variation de la fréquence F2 du signal de sortie de l'oscillateur capteur 2 (courbe B) est choisie monotone de façon qu'à une fréquence F2 donnée ne corresponde qu'une seule valeur de température. L'oscillateur capteur 2 est formé d'un circuit oscillateur INTERSIL 7038, associé à un résonateur au tantalate pour donner une fréquence F2 de 4,8 MHz ; la figure 3 montre que, pour une température qui varie de $- 40$ à $+ 85°C$, la fréquence F2 dérive de $5.10^{-3}$ (courbe B).

Les signaux à fréquence F1 et F2, délivrés respectivement par l'oscillateur pilote 1 et l'oscillateur capteur 2 de la figure 1, sont envoyés sur les deux entrées d'un mélangeur de fréquences, 3, qui fournit, sur sa sortie, un signal de fréquence F3 = F1 - F2 = 200 kHz.

Un fréquencemètre numérique, 4, mesure la fréquence du signal F3 ; pour cela il reçoit sur son entrée de mesure le signal du mélangeur 3 et il reçoit comme signal donnant une fréquence de référence, F4, le signal de sortie d'un diviseur de fréquence, 5, de rapport $N = 5.10^{6}$ dont le signal d'entrée est le signal délivré par l'oscillateur pilote 1 ; le signal à la fréquence F4 est formé d'impulsions de 0,2µS dont la fréquence de répétition est de 1 Hz (F4 = $\frac{F1}{N}$ = 1 Hz).

La dérive en fréquence, dF3, du signal de sortie du mélangeur 3 est sensiblement égale à celle de l'oscillateur capteur 2 vu que dF3 = dF2 + dF1 et que la dérive dF1 de l'oscillateur pilote 1 est négligeable devant la dérive dF2 de l'oscillateur capteur 2, comme cela a été indiqué plus avant. Le mélangeur 3 présente un double intérêt : d'une part il permet d'employer, comme fréquencemètre 4, un circuit pour la mesure d'une fréquence F3 de l'ordre de 200 kHz qui consomme donc nettement moins qu'un fréquencemètre travaillant à une fréquence F2 de l'ordre de 4,8 MHz, d'autre part il délivre au fréquencemètre un signal dont la variation relative $\frac{dF3}{F3}$ est nettement supérieure à celle, $\frac{dF2}{F2}$, du signal de l'oscillateur capteur 2 puisque dF3 est équivalent à dF2 et que F3 est inférieur à F2.

Comme le montre la figure 3, le fréquencemètre 4 comporte un circuit de comptage 40 ; pendant les périodes du signal F4, c'est-à-dire pendant des périodes de 1 seconde, le circuit de comptage, 40, compte modulo 2048 les périodes du signal de sortie du mélangeur 3 ; pour cela, le circuit de comptage est remis à zéro, au moment de l'apparition des fronts arrières des impulsions de 0,2µS du signal F4, grâce à un circuit différentiateur 41. Le contenu du compteur est transféré dans un registre de sortie à 11 étages, 42, lors de l'apparition d'un signal représentatif du front avant des impulsions du signal F4, donné par le circuit différentiateur 41.

Les m = 11 sorties du registre du fréquencemètre sont réunies (figure 1) à m = 11 entrées d'adressage d'une mémoire programmable, 6, connue sous le nom de mémoire PROM, de type 27.16 ; cette mémoire délivre des mots de 8 bits sur ses n = 8 sorties.

Les signaux de sortie de la mémoire 6 sont utilisés comme signaux de commande des n = 8 commutateurs S1 à Sn, d'un circuit de commutation 7. Les commutateurs S1 à Sn sont des transistors de type MOS qui sont bloqués ou saturés selon qu'ils reçoivent des signaux de niveau logique "0" ou "1" en provenance de la mémoire 6.

Ce circuit de commutation 7 sert à commander la mise en parallèle, sur un condensateur, C, d'entrée de l'oscillateur pilote 1, des n = 8 condensateurs C1 à Cn d'une boîte de condensateurs, 8.

Les condensateurs de la boîte 8 ont respectivement pour valeurs 0,5 - 1 - 2 - 4 - 8 - 16 - 33 et 68 pF ; ils ont été choisis pour permettre une compensation de la dérive en température de l'oscillateur pilote 1 entre - 40 et + 85°C. Pour cela, des mesures préalables sont effectuées pour déterminer les valeurs à donner au condensateur à mettre en parallèle sur le condensateur C afin d'obtenir une fréquence F1 de

l'oscillateur pilote 1 égale à 5 MHz, pour différentes valeurs de température, c'est-à-dire pour différentes valeurs de F3 mesurées grâce au fréquencemètre 4 ; la mémoire 6 est alors programmée pour que, à chaque valeur donnée par le fréquencemètre 4, corresponde une valeur de capacité de la boîte de condensateurs 8, mise en parallèle sur le condensateur C.

Avec le montage selon la figure 1 il a été possible de réduire à $5.10^{-7}$ la dérive de l'oscillateur pilote 1 pour un fonctionnement entre – 40 et + 85°C alors que cette dérive, sans compensation, était de $2.10^{-5}$.

Une variante au générateur de fréquence compensé en température de la figure 1, est donnée à la figure 4. La figure 4 est une vue partielle d'un générateur de fréquence qui ne se distingue de celui selon la figure 1 que par le remplacement du circuit de commutation 7 par un convertisseur numérique-analogique, 70, et par le remplacement de la boîte de condensateurs 8 par une diode à capacité variable, 80, aussi appelée varicap, branchée en parallèle sur le condensateur C. Le convertisseur numérique-analogique 70 reçoit les signaux de sortie de la mémoire 6 et est réglé de manière à fournir à la diode à capacité variable, la tension de polarisation qui détermine la capacité voulue pour compenser la dérive en température.

L'invention n'est pas limitée aux deux exemples décrits, c'est ainsi que la mesure de température peut s'effectuer sans le mélangeur 6, c'est-à-dire par la mesure directe de la fréquence F2 ; là encore la dérive en température de l'oscillateur capteur 2 doit être nettement plus importante que celle de l'oscillateur pilote 1 dans la mesure où la fréquence de référence du fréquencemètre 4 est obtenue à partir du signal fourni par l'oscillateur pilote 1.

0133388

## REVENDICATIONS

1. Générateur de fréquence compensé en température, comprenant un oscillateur pilote à résonateur piézo-électrique (1) pour fournir un signal de sortie à fréquence stable (F1), des moyens de mesure (2, 3, 4, 5) pour effectuer une mesure de la température de l'oscillateur pilote, des moyens de réglage (7,8 - 70, 80) reliés à une entrée de commande de la fréquence de l'oscillateur pilote et un circuit de commande (6), couplé aux moyens de mesure et comportant une mémoire (6), pour commander les moyens de réglage en fonction du résultat de la mesure, les moyens de mesure comportant un oscillateur (2) utilisé comme oscillateur capteur, et un fréquencemètre (4) ayant une entrée de mesure couplée à la sortie de l'oscillateur capteur, caractérisé en ce que l'oscillateur capteur est un oscillateur à résonateur piézo-électrique dont la dérive en température est monotone et très supérieure (au moins de l'ordre de 20 fois) à celle de l'oscillateur pilote dans la bande des températures de fonctionnement de l'oscillateur pilote.

2. Générateur de fréquence selon la revendication 1, caractérisé en ce que les moyens de mesure comportent un mélangeur (3) ayant deux entrées respectivement couplées à l'oscillateur pilote et à l'oscillateur capteur et une sortie couplée au fréquencemètre.

3. Générateur de fréquence, selon l'une des revendications précédentes, caractérisé en ce que les moyens de réglage comportent un circuit de commutation (7) commandé par le circuit de commande et une boîte de condensateurs (8) reliée à l'entrée de commande de l'oscillateur pilote et dont les condensateurs (C1-Cn) sont connectés par le circuit de commutation.

4. Générateur de fréquence selon l'une quelconque des revendications 1 et 2, caractérisé en ce que les moyens de réglage comportent une diode à capacité variable (80) reliée à l'entrée de commande de l'oscillateur pilote et un convertisseur numérique-analogique pour coupler la mémoire à la diode.

Fig.1

Fig.2

Fig.4

Fig.3

0133388

1/1

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. 3) |
|---|---|---|---|
| Y | US-A-3 713 033 (FRERKING) <br> * colonne 1, ligne 66 - colonne 6, ligne 58; figures 1,2 * | 1-4 | H 03 L 1/02 |
| | --- | | |
| Y | US-A-4 160 183 (KUSTERS et al.) <br> * colonne 3, ligne 1 - colonne 8, ligne 9; figure 3 * | 1-4 | |
| | --- | | |
| A | US-A-3 690 546 (UEHARA) <br> * colonne 1, ligne 60 - colonne 3, ligne 67; figures 2,3 * | 3 | |

DOMAINES TECHNIQUES RECHERCHES (Int. Cl. 3)

H 03 L
H 03 H

Le présent rapport de recherche a été établi pour toutes les revendications

| Lieu de la recherche | Date d'achèvement de la recherche | Examinateur |
|---|---|---|
| LA HAYE | 18-09-1984 | DHONDT I.E.E. |